# EUROPEAN PATENT APPLICATION

(11) **EP 1 921 727 A2**
(43) Date of publication of application: **14.05.2008**
(21) Application number: 07254374.7
(22) Date of filing: 06.11.2007
(51) Int. Cl.: H02J 7/00

(54) **Hybrid battery and charging method thereof**

(30) Priority: 06.11.2006 KR 20060109143
(71) Applicant: Samsung SDI Co., Ltd., Suwon-si, Gyeonggi-do 442-390 (KR)
(72) Inventor: Yun, Changyong, Gyeonggi-do (KR)
(74) Representative: Mounteney, Simon James

(57) **Abstract**

A hybrid battery includes a first chargeable power supply, a second chargeable power supply coupled in parallel with the first chargeable power supply. A controller pre-charges, fast-charges and full-charges sequentially the first chargeable power supply and the second chargeable power supply while sensing the charging voltage of the first chargeable power supply and the second chargeable power supply.

## Description

### BACKGROUND

### 1. Field of the Invention

The present invention relates to a hybrid batteries, and, more particularly, to a hybrid battery and a charging method thereof that can raise the charging efficiency.

### 2. Description of the Prior Art

Portable electronic devices are typically supplied with electric power by a chargeable battery. The usable time of the portable electronic device is determined by the time during which the electric power can be supplied by the battery. Hence, in order to extend the usable time of the portable electronic device, the battery is regularly charged.

To further maximize the usable time of the portable electronic device, two batteries can be mounted in one portable electronic device. However, the price of such an arrangement becomes expensive because control circuits need to be separately installed in respective batteries and a microcomputer or a fuel gage circuit for calculating the capacity of each battery is typically provided.

Moreover, the size becomes large and the energy efficiency per volume is lowered because two batteries having the same shape, chemical property, capacity, charging voltage or charging current are collectively mounted in one device.

Furthermore, since conventionally one battery is pre-charged, fast-charged and full-charged sequentially and then the other battery is subsequently charged in the same sequence, the charging for the combination takes too much time. For example, assuming that when charging a battery, pre-charging time is approximately from 30 minutes to an hour, fast-charging time is approximately an hour, and full-charging time is approximately an hour, the time for charging two batteries completely is approximately from five hours to six hours. Further, taking into consideration that after completing the fast-charging of the battery, the battery is actually charged up to 80% of its total capacity, the above-mentioned method, in which after pre-charging, fast-charging and full-charging one battery the other battery is also pre-charged, fast-charged and full-charged, becomes inefficient.

### SUMMARY OF THE INVENTION

In accordance with the present invention a hybrid battery and a charging method thereof is provided that can raise the charging efficiency by charging at least two batteries sequentially or in parallel.

A hybrid battery according to embodiments of the present invention includes a first chargeable power supply and second chargeable power supply coupled in parallel with the first chargeable power supply. A controller pre-charges, fast-charges and full-charges sequentially the first chargeable power supply and the second chargeable power supply while sensing the charging voltage of the first chargeable power supply and the second chargeable power supply.

The controller can pre-charge sequentially the first chargeable power supply and the second chargeable power supply for a pre-charge length of time, then fast-charge sequentially the first chargeable power supply and the second chargeable power supply for a fast-charge length of time, and then full-charge sequentially the first chargeable power supply and the second chargeable power supply for a full-charge length of time.

According to a first aspect of the invention there is provided a hybrid battery as set out in claim 1. Preferred features of this aspect are set out in claims 2-13. According to a second aspect of the invention there is provided a charging method for a hybrid battery as set out in claim 14. Preferred features of this aspect are set out in claims 15-21.

According to the hybrid battery and its charging method for aspects of the present invention, it is possible to maximize the charging capacity per charging time by pre-charging, fast-charging and full-charging the first chargeable power supply and the second chargeable power supply sequentially or in parallel. For example, if the charging capacity of about 80% is obtained by fast-charging for about an hour, then the remaining charging capacity of 20% is obtained by full-charging for about an hour.
That is, the charging capacity of about 100% is obtained by charging for about two hours. Hence, when the first chargeable power supply is fast-charged for an hour, then the second chargeable power supply is subsequently fast-charged for an hour, and then the charging is stopped, the charging capacity of 80% per each chargeable power supply is obtained, and thus the total charging capacity of 160% is obtained. On the contrary, if the first chargeable power supply is fast-charged (for an hour) and full-charged (for an hour) for two hours and then the charging is stopped, then only the first chargeable power supply obtains the charging capacity of 100% and the second chargeable power supply obtains the charging capacity of 0%. That is, in this case, only the total charging capacity of 100% is obtained. As a result, it is more preferable in terms of the charging efficiency that each battery is sequentially fast-charged as described above. Here, the pre-charging is not considered.

Moreover, according to embodiments of the present invention, a single controller operates the charging of the first chargeable power supply and the second chargeable power supply in a combined manner, and thus the circuit is simplified and the manufacturing cost is lowered.

Furthermore, according to embodiments of the present invention, the first chargeable power supply and the second chargeable power supply having different shapes, chemical properties, capacities, charging voltages or charging currents are employed, and thus space can be significantly saved and the energy efficiency per volume can be raised.

### BRIEF DESCRIPTION OF THE DRAWINGS

FIG. 1 is a block diagram showing the circuit of a hybrid batteryaccording to an embodiment of the present invention.

FIG. 2a is a circuit diagram showing the relationship between a pre-charge/charge/discharge switch and a main protection circuit of a hybrid battery according to an embodiment of the present invention, and FIG. 2b is a circuit diagram showing the relationship between a sub protection circuit and a fuse.

FIGS. 3a and 3b are respectively a flow chart and a timing chart showing a charging method for a hybrid battery according to an embodiment of the present invention.

FIGS. 4a and 4b are respectively a flow chart and a timing chart showing a charging method for a hybrid battery according to another embodiment of the present invention.

FIGS. 5a and 5b are respectively a flow chart and a timing chart showing a charging method for a hybrid battery according to another embodiment of the present invention.

### DETAILED DESCRIPTION

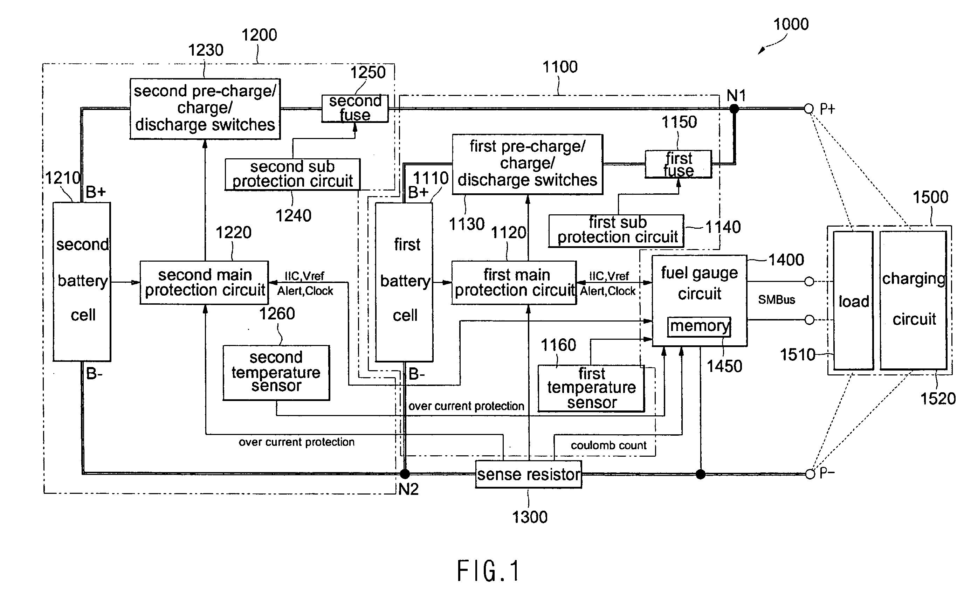

Referring to FIG. 1, a hybrid battery 1000 in accordance with an embodiment of the present invention includes a first chargeable power supply 1100, a second chargeable power supply 1200, a sense resistor 1300 and a controller 1400.

The first chargeable power supply 1100 includes a first battery cell 1110, a first main protection circuit 1120, a first pre-charge/charge/discharge switch 1130, a first sub protection circuit 1140, a first fuse 1150 and a first temperature sensor 1160. The first battery cell 1110 can have a form in which at least one chargeable and dischargeable secondary battery is coupled in series and/or in parallel. For example, the secondary battery may be any one battery selected from a cylindrical lithium ion battery, a polygonal lithium ion battery, a pouch-shaped lithium polymer battery, a pouch-shaped lithium ion battery or their equivalents, but is not limited thereto.

The first main protection circuit 1120 senses a charging voltage or a discharging voltage of the first battery cell 1110 and transmits the sensed value to the controller 1400. The first main protection circuit 1120 turns on or turns off the first pre-charge/charge/discharge switch 1130 by a control signal of the controller 1400 such as one of a pre-charge start signal, a pre-charge stop signal, a fast-charge (or full-charge) start signal, a fast-charge (or full-charge) stop signal, a discharge start signal and a discharge stop signal. Furthermore, the first main protection circuit 1120 can sense a current signal from the sense resistor 1300 and, if the sensed value is determined to be an over current, turn off the first pre-charge/charge/discharge switch 1130. The connection relationship between the first main protection circuit 1120 and the first pre-charge/charge/discharge switch 1130 will be described below in more detail.

The first pre-charge/charge/discharge switch 1130 may be three switches coupled in series to a charging and discharging path between a pack positive electrode terminal P+ and a positive electrode terminal B+ of the first battery cell 1110. The first pre-charge/charge/discharge switch 1130 is turned on and turned off by a control signal by means of the first main protection circuit 1120. However, in an alternative embodiment the first pre-charge switch can be omitted.

The first sub protection circuit 1140 blows out the first fuse 1150 and blocks the charging and discharging path, when, for example, the first main protection circuit 1120 or the first pre-charge/charge/discharge switch 1130 is not operating normally.

The first fuse 1150 is coupled in series to the charging and discharging path between the pack positive electrode terminal P+ and the first pre-charge/charge/discharge switch 1130. As described above, the first fuse 1150 is blown out by a control signal of the first sub protection circuit 1140 and has a property in which once the first fuse is blown out, it cannot be restored. However, in an alternative embodiment the first sub protection circuit 1140 and the first fuse 1150 can be omitted.

The first temperature sensor 1160 senses the temperature of the first battery cell 1110 and transmits the sensed value to the controller 1400. The controller 1400 transmits a charge or discharge stop signal to the first main protection circuit 1120 when a temperature obtained from the first temperature sensor 1160 is above a permissible temperature, and thus enables the first main protection circuit 1120 to turn off at least one of the first pre-charge/charge/discharge switch 1130 and to block the charging and discharging path. By doing so, overheating of the first battery cell 1110 is prevented. The controller 1400 also uses the temperature obtained from the first temperature sensor 1160 for compensating the battery capacity. Since such a compensating method for a battery according to a temperature is already known to those skilled in the art, and the compensating method will not be explained herein. However, in an alternative embodiment the first temperature sensor 1160 can be omitted.

Similarly, the second chargeable power supply 1200 can include a second battery cell 1210, a second main protection circuit 1220, a second pre-charge/charge/discharge switch 1230, a second sub protection circuit 1240, a second fuse 1250 and a second temperature sensor 1260. The second battery cell 1210 is at least one chargeable and dischargeable secondary battery and can have a form of being coupled in series and/or in parallel. For example, the secondary battery may be any one battery selected from a cylindrical lithium ion battery, a polygonal lithium ion battery, a pouch-shaped lithium polymer battery, a pouch-shaped lithium ion battery or their equivalents, but not limited thereto.

Shapes, chemical properties, capacities, charging voltages or charging currents of the first battery cell 1110 of the first chargeable power supply 1100 and the second battery cell 1210 of the second chargeable power supply 1200 can be different from each other. For example, if the first battery cell 1110 is a cylindrical lithium ion battery, then the second battery cell 1210 may be any one battery selected from a polygonal lithium ion battery, a pouch-shaped lithium polymer battery, a pouch-shaped lithium ion battery or their equivalents. Moreover, if the first chargeable power supply 1100 is a lithium-based battery cell, then the second battery cell 1210 may be any one battery selected from a nickel-cadmium battery, a nickel-hydrogen battery or their equivalents. Furthermore, capacities of the first chargeable power supply 1100 and the second chargeable power supply 1200 can be different from each other. In addition, charging voltages and charging currents of the first chargeable power supply 1100 and the second chargeable power supply 1200 can be different from each other.

The second main protection circuit 1220 senses a charging voltage or a discharging voltage of the second battery cell 1210 and transmits the sensed value to the controller 1400. Moreover, the second main protection circuit 1220 turns on or turns off the second pre-charge/charge/discharge switch 1230 by a control signal of the controller 1400 such as one of a pre-charge start signal, a pre-charge stop signal, a fast-charge (or full-charge) start signal, a fast-charge (or full-charge) stop signal, a discharge start signal and a discharge stop signal. Furthermore, the second main protection circuit 1220 can sense a current signal from the sense resistor 1300 and, if the sensed value is determined to be an over current, turns off the second pre-charge/charge/discharge switch 1230.

The second pre-charge/charge/discharge switch 1230 may be three switches that are coupled in series to a charging and discharging path between the pack positive electrode terminal P+ and a positive electrode terminal B+ of the second battery cell 1210. The second pre-charge/charge/discharge switch 1230 is turned on and turned off by a control signal by means of the second main protection circuit 1220. However, in an alternative embodiment the second pre-charge switch can be omitted.

The second sub protection circuit 1240 blows out the second fuse 1250, for example, when the second pre-charge/charge/discharge switch 1230 is not operated normally.

The second fuse 1250 is coupled in series to the charging and discharging path between the pack positive electrode terminal P+ and the second pre-charge/charge/discharge switch 1230. As described above, the second fuse 1250 is blown out by a control signal of the second sub protection circuit 1240 and has the property such that once the second fuse is blown out, it cannot be restored. However, in an alternative embodiment the second sub protection circuit 1240 and the second fuse 1250 can be omitted.

The second temperature sensor 1260 senses a temperature of the second battery cell 1210 and transmits the sensed value to the controller 1400. The controller 1400 transmits a charge or discharge stop signal to the second main protection circuit 1220 when a temperature obtained from the second temperature sensor 1260 is above a permissible temperature, and thus enables the second main protection circuit 1220 to turn off at least one of the second pre-charge/charge/discharge switch 1230 and to block the charging and discharging path. By doing so, overheating of the second battery cell 1210 is prevented. Moreover, as described above, the controller 1400 also compensates the battery capacity using the temperature obtained from the second temperature sensor 1260. However, in an alternative embodiment the second temperature sensor 1260 can be omitted.

The second fuse 1250 (or the first fuse 1150) and the second sub protection circuit 1240 (or the first sub protection circuit 1140) may not be employed as constituent elements of embodiments of the present invention. In other words, if the first fuse 1150 (or the second fuse 1250) is installed between a node N1 and the pack positive electrode terminal P+ and a program is set such that the first sub protection circuit 1140 (or the second sub protection circuit 1240) is operated when the first main protection circuit 1120 or the second main protection circuit 1220 and so forth is not operated normally, then the second fuse 1250 (or the first fuse 1150) and the second sub protection circuit 1240 (or the first sub protection circuit 1140) may be omitted.

The sense resistor 1300 can be installed in series to a charging and discharging path between a pack negative electrode terminal P- and a node N2. The sense resistor 1300 converts a voltage applied thereto into a current and transmits it to the controller 1400, the first main protection circuit 1120 and the second main protection circuit 1220 respectively. As described above, the sense resistor 1300 informs the first main protection circuit 1120 and the second main protection circuit 1220 whether the converted current is an over current or not and enables the controller 1400 to integrate the current.

Furthermore, it is shown in FIG. 1 that one sense resistor 1300 is installed, however, two or three sense resistors can be installed in other embodiments. For example, the sense resistor 1300 can be installed between a negative electrode terminal B- of the first battery cell 1110 and the node N2, between a negative electrode terminal B- of the second battery cell 1210 and the node N2 and between the pack negative electrode terminal P- and the node N2 respectively. If these three sense resistors 1300 are installed, then a current accumulation and an over current flowing through each of the first battery cell 1110 and the second battery cell 1210 can be detected more accurately and a current accumulation and an over current flowing through the entire first and second battery cells 1110 and 1210 can also be detected more accurately.

The controller 1400 may be a fuel gage IC or a microcomputer having a memory 1410 and various input/output ports therein. As described above, the controller 1400 obtains the voltage information of the first battery cell 1110 from the first main protection circuit 1120 of the first chargeable power supply 1100, obtains the voltage information of the second battery cell 1210 from the second main protection circuit 1220 of the second chargeable power supply 1200, and obtains the current information (a current accumulation) from the sense resistor 1300. Moreover, the controller 1400 obtains the temperature information of the first battery cell 1110 from the first temperature sensor 1160 of the first chargeable power supply 1100 and obtains the temperature information of the second battery cell 1210 from the second temperature sensor 1260 of the second chargeable power supply 1200.

The controller 1400 calculates the total capacity and the remaining capacity of the first chargeable power supply 1100 and the second chargeable power supply 1200 by carrying out the coulomb count (the current integration) based on the current accumulation obtained from the sense resistor 1300. Since the calculation of the total and remaining capacities of the battery can be performed in various ways and the method thereof is well known to those skilled in the art, the method will not be described in detail herein. The controller 1400 calculates the remaining capacities of the first chargeable power supply 1100 and the second chargeable power supply 1200 respectively, adds the remaining capacities of both batteries and transmits it to an external system 1500 (a load 1510) through a communication line, such as an SMBus. Accordingly, it appears that a single battery is coupled through the external system 1500, i.e., the load 1510, and thus the total capacity of the battery can be readily verified.

The controller 1400 obtains the charging voltage information and the discharging voltage information from the first main protection circuit 1120 of the first chargeable power supply 1100, transmits the charge stop signal to the first main protection circuit 1120 when the charging voltage is determined to be an over-charging voltage, and transmits the discharge stop signal to the first main protection circuit 1120 when the discharging voltage is determined to be an over-discharging voltage. The first main protection circuit 1120 turns off the first fast-charge switch when the charge stop signal is transmitted and turns off the first discharge switch when the discharge stop signal is transmitted.

Moreover, the controller 1400 obtains the charging voltage information and the discharging voltage information from the second main protection circuit 1220 of the second chargeable power supply 1200, transmits the charge stop signal to the second main protection circuit 1220 when the charging voltage is determined to be an over-charging voltage, and transmits the discharge stop signal to the second main protection circuit 1220 when the discharging voltage is determined to be an over-discharging voltage. The second main protection circuit 1220 turns off the second fast-charge switch when the charge stop signal is transmitted and turns off the second discharge switch when the discharge stop signal is transmitted.

Furthermore, the controller 1400 operates so that electric power from only one of the first chargeable power supply 1100 and the second chargeable power supply 1200 is supplied to the external system 1500. For example, if the controller 1400 allows the electric power from only the first chargeable power supply 1100 to be supplied to the load 1510, the controller 1400 prevents the second chargeable power supply 1200 from being charged by the first chargeable power supply 1100 by transmitting the charge stop signal and the discharge stop signal to the second chargeable power supply 1200. By doing so, the discharging of the second chargeable power supply 1200 is also prevented. Moreover, if the controller 1400 allows the electric power from only the second chargeable power supply 1200 to be supplied to the load 1510, the controller 1400 prevents the first chargeable power supply 1100 from being charged by the second chargeable power supply 1200 by transmitting the charge stop signal and the discharge stop signal to the first chargeable power supply 1100. By doing so, the discharging of the first chargeable power supply 1100 is also prevented. It is a precondition that such a behaviour is carried out only when the pack positive electrode terminal P+ and the pack negative electrode terminal P- are coupled with the load 1510. That is, when the pack positive electrode terminal P+ and the pack negative electrode terminal P- are coupled with a charging circuit 1520, somewhat different mechanism can be provided. In other words, when the charging circuit 1520 is coupled, the controller 1400 operates so that the first chargeable power supply 1100 and the second chargeable power supply 1200 can be charged sequentially or can be charged simultaneously. The charging method for the first chargeable power supply 1100 and the second chargeable power supply 1200 by the controller 1400 will be described below in more detail.

Moreover, if temperature information obtained from the first temperature sensor 1160 of the first chargeable power supply 1100 is determined to be higher than a permissible temperature, the controller 1400 allows the first main protection circuit 1120 to block the charging and discharging path by transmitting the charge stop signal or the discharge stop signal to the first main protection circuit 1120. That is, the first main protection circuit 1120 prevents the overheating of the first battery cell 1110 by turning off the first fast-charge switch or the second discharge switch.

Furthermore, if temperature information obtained from the second temperature sensor 1260 of the second chargeable power supply 1200 is determined to be higher than a permissible temperature, the controller 1400 allows the second main protection circuit 1220 to block the charging and discharging path by transmitting the charge stop signal or the discharge stop signal to the second main protection circuit 1220. That is, the second main protection circuit 1220 prevents the overheating of the second battery cell 1210 by turning off the first fast-charge switch or the second discharge switch.

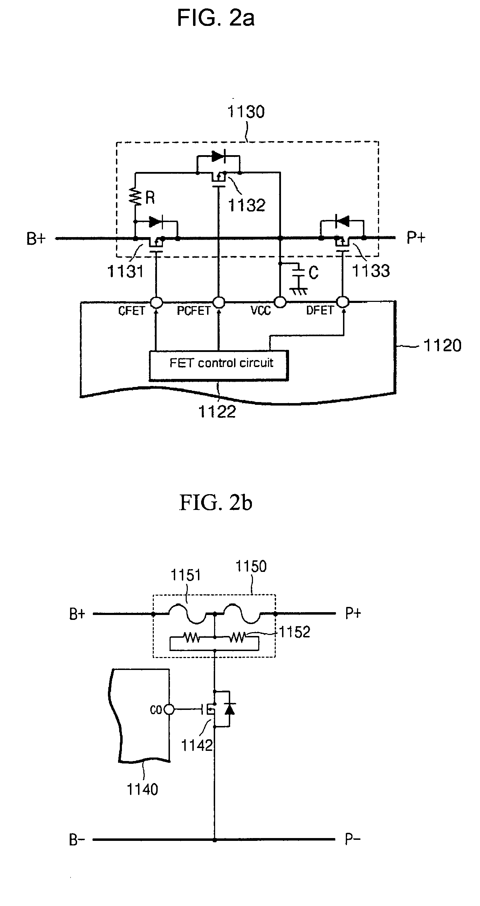

FIG. 2a is a circuit diagram showing the relationship between the first pre-charge/charge/discharge switch 1130 and the first main protection circuit 1120 of the hybrid battery 1000 according to an embodiment of the present invention, and FIG. 2b is a circuit diagram showing the relationship between the first sub protection circuit 1140 and the fuse 1150.

The circuit shown in FIG. 2a is a circuit of the first pre-charge/charge/discharge switch 1130 and the first main protection circuit 1120 of the first chargeable power supply 1100. However, a comparable circuit can be implemented for the second chargeable power supply 1200. Hence, the explanation about the detailed circuit and the operation of the second pre-charge/charge/discharge switch 1230 and the second main protection circuit 1220 installed in the second chargeable power supply 1200 will be omitted.

A first fast-charge switch 1131, a first pre-charge switch 1132 and a first discharge switch 1133 are sequentially coupled to the charging and discharging path between the pack positive electrode terminal P+ and the positive electrode terminal B+ of the first battery cell 1110. That is, the first fast-charge switch 1131 and the first discharge switch 1133 are coupled in series to the charging and discharging path, and the first pre-charge switch 1132 is coupled in parallel to the charging and discharging path. All the switches 131, 132, 133 may be P channel field effect transistors with a parasite diode that has a forward diode characteristic from a drain to a source, but is not limited thereto. A source of the first fast-charge switch 1131 and a source of the first discharge switch 1133 are coupled with each other. Moreover, a drain of the first fast-charge switch 1131 is coupled with the positive electrode terminal B+ of the first battery cell 1110, and a drain of the first discharge switch 1131 is coupled with the pack positive electrode terminal P+. Furthermore, a source of the first pre-charge switch 1132 is coupled with sources of the first fast-charge switch 1131 and the first discharge switch 1133 respectively, and a drain thereof is coupled with the drain of the first fast-charge switch 1131 via a resistor R. Reference numeral "C" denotes a capacitor coupled for restraining the fluctuation of electric power.

In addition, gates of the first fast-charge switch 1131, the first pre-charge switch 1132 and the first discharge switch 1133 are controlled by the first main protection circuit 1120 respectively. For example, if the first main protection circuit 1120 applies a low signal through a CFET terminal, then the first fast-charge switch 1131 is turned on, if the first main protection circuit 1120 applies a low signal through a PCFET terminal, then the first pre-charge switch 1132 is turned on, and if the first main protection circuit 1120 applies a low signal through a DFET terminal, then the first discharge switch 1133 is turned on. On the other hand, if the first main protection circuit 1120 applies a high signal through the CFET terminal, then the first fast-charge switch 1131 is turned off, if the first main protection circuit 1120 applies a high signal through the PCFET terminal, then the first pre-charge switch 1132 is turned off, and if the first main protection circuit 1120 applies a high signal through the DFET terminal, then the first discharge switch 1133 is turned off. In order to control the voltage of the gates of the respective switches 1131, 1132 and 1133, a FET control circuit 1122 can be embedded in the first protection circuit 1120.

According to this circuit, when the first main protection circuit 1120 turns off the first fast-charge switch 1131, the fast-charging (or the full-charging) of the first battery cell 1110 is stopped (the discharging thereof is possible due to a parasite diode), and when the first main protection circuit 1120 turns off the first discharge switch 1133, the discharging of the first battery cell 1110 is stopped (the charging thereof is possible due to a parasite diode). As is well known, when a voltage of the first battery cell 1110 is lowered below an over-discharging voltage, the first pre-charge switch 1132 lowers the charging current and supplies it to the battery cell for a pre-charge length of time, and thus allows a voltage of the first battery cell 1110 to be sufficient for fast-charging. Since the operation of the first fast-charge switch 1131, the first pre-charge switch 1132 and the first discharge switch 1133 is well known to those skilled in the art, further explanation about it will be omitted.

The circuit shown in FIG. 2b is a circuit of the first fuse 1150 and the first sub protection circuit 1140 of the first chargeable power supply 1100. However, a comparable circuit can be implemented for the second chargeable power supply 1200. Hence, the explanation about the circuit and operation of the second fuse 1250 and the second sub protection circuit 1240 of the second chargeable power supply 1200 will be omitted.

As shown in the drawing, the first fuse 1150 is installed in the charging and discharging path between the pack positive electrode terminal P+ and the positive electrode terminal B+ of the first battery cell 1100. Moreover, a first switch 1142 for operating the first fuse 1150 is coupled to the charging and discharging path between the pack negative electrode terminal P- and the negative electrode terminal B- of the first battery cell 1100. Furthermore, the first switch 1142 is coupled with a CO terminal of the first sub protection circuit 1140.

The first fuse 1150 can include at least one temperature fuse 1151 and a heating resistor 1152 that fuses the temperature fuse 1151 and blows out the same. Moreover, the first switch 1142 may be an ordinary N channel field effect transistor, but not limited thereto.

Accordingly, when the first sub protection circuit 1140 applies a high signal through the CO terminal, the first switch 1142 is turned on, and thus the charging current or the discharging current flows to the negative electrode terminal B- or P-through the positive electrode terminal B+ or P+, the temperature fuse 1151, the heating resistor 1152 and drain sources of the switch 1142. Hence, the heating resistor 1152 generates heat and the temperature fuse 1151 is blown out, and thus the charging and discharging path is permanently blocked. The first sub protection circuit 1140 operates when the first main protection circuit 1120 or the first pre-charge/charge/discharge switch 1130 is not normally operated.

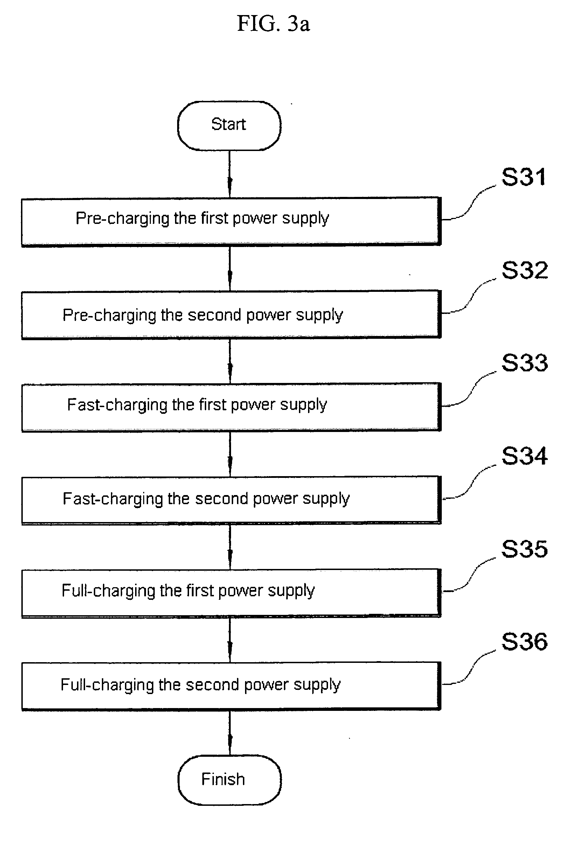

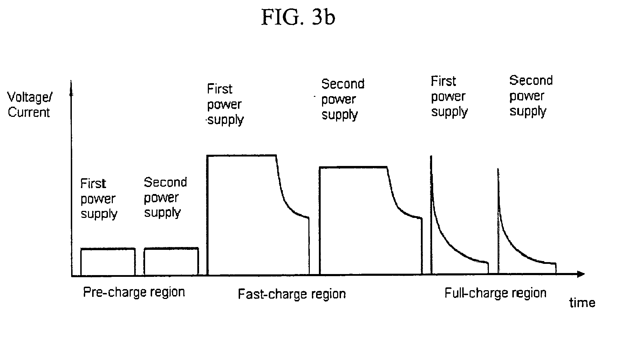

FIGS. 3a and 3b are respectively a flow chart and a timing chart showing a charging method for the hybrid battery 1000 according to an embodiment of the present invention.

As shown in the drawing, a charging method for the hybrid battery 1000 according to an embodiment of the present invention includes: pre-charging the first chargeable power supply 1100 for a pre-charge length of time S31; pre-charging the second chargeable power supply 1200 for a pre-charge length of time S32; fast-charging the first chargeable power supply 1100 for a fast-charge length of time S33; fast-charging the second chargeable power supply 1200 for a fast-charge length of time S34; full-charging the first chargeable power supply 1100 for a full-charge length of time S35; and full-charging the second chargeable power supply 1200 for a full-charge length of time S36.

The charging method for the hybrid battery 1000 according to an embodiment of the present invention will now be described more specifically with reference to FIGS. 1, 2a and 2b. It is assumed that the charging circuit 1520 of the external system 1500 is coupled to the pack positive electrode terminal P+ and the pack negative electrode terminal P- and that the first chargeable power supply 1100 and the second chargeable power supply 1200 are all over-discharged. For a chargeable power supply that is not over-discharged among the first chargeable power supply 1100 and the second chargeable power supply 1200, the following pre-charging step will be omitted.

In pre-charging the first chargeable power supply 1100 for a pre-charge length of time S31, the controller 1400 allows the first main protection circuit 1120 to turn on the first pre-charge switch 1132 by transmitting the pre-charge start signal to the first main protection circuit 1120 of the first chargeable power supply 1100. That is, the first main protection circuit 1120 is allowed to turn on the first pre-charge switch 1132 coupled between the first battery cell 1110 and the first fuse 1150. The controller 1400 allows the first fast-charge switch 1131 to be turned off. Moreover, at this time, the controller 1400 allows the second main protection circuit 1220 to turn off the second pre-charge switch by transmitting the pre-charge stop signal to the second main protection circuit 1220. That is, the second main protection circuit 1220 is allowed to turn off the second pre-charge switch coupled between the second battery cell 1210 and the second fuse 1250. At this time, the controller 1400 allows the second fast-charge switch to be turned off. By this operation, the charging current from the charging circuit 1520 is supplied only to the first chargeable power supply 1100. That is, the charging current from the charging circuit 1520 flows through the pack positive electrode terminal P+, the first fuse 1150, the first pre-charge switch 1132, the positive electrode terminal B+ of the first battery cell 1110, the negative electrode terminal B- of the first battery cell 1110 and the sense resistor 1300, and thus only the first battery cell 1110 is pre-charged.

The controller 1400 operates so that a pre-charging current when pre-charging the first chargeable power supply 1100 is lower than a fast-charging current when fast-charging the first chargeable power supply, and thus prevents the deterioration phenomenon of the first battery cell 1110. When pre-charging the first chargeable power supply 1100, if the voltage of the first battery cell 1110 detected from the first main protection circuit 1120 is, for example, about 3 volts per cell, the controller 1400 stops the pre-charging for the next fast-charging.

Next, in pre-charging the second chargeable power supply 1200 for a pre-charge length of time S32, the controller 1400 allows the second main protection circuit 1220 to turn on the second pre-charge switch by transmitting the pre-charge start signal to the second main protection circuit 1220 of the second chargeable power supply 1200. That is, the second main protection circuit 1220 is allowed to turn on the second pre-charge switch coupled between the second battery cell 1210 and the second fuse 1250. At this time, the controller 1400 allows the second fast-charge switch to be turned off. Moreover, at this time, the controller 1400 allows the first main protection circuit 1120 to turn off the first pre-charge switch 1132 by transmitting the pre-charge stop signal to the first main protection circuit 1120. That is, the first main protection circuit 1120 is allowed to turn off the first pre-charge switch 1132 coupled between the first battery cell 1110 and the first fuse 1150. At this time, the controller 1400 allows the first fast-charge switch to be turned off. By this operation, the charging current from the charging circuit 1520 is supplied only to the second chargeable power supply 1200. That is, the charging current from the charging circuit 1520 flows through the pack positive electrode terminal P+, the second fuse 1250, the second pre-charge switch, the positive electrode terminal B+ of the second battery cell 1210, the negative electrode terminal B- of the second battery cell 1210 and the sense resistor 1300, and thus only the second battery cell 1210 is pre-charged.

The controller 1400 operates so that a pre-charging current when pre-charging the second chargeable power supply 1200 is lower than a fast-charging current when fast-charging the second chargeable power supply, and thus prevents the deterioration phenomenon of the second battery cell 1210. When pre-charging the second chargeable power supply 1200, if the voltage of the second battery cell 1210 detected from the second main protection circuit 1220 is, for example, about 3 volts per cell, the controller 1400 stops the pre-charging for the next fast-charging. Moreover, since the structure and the shape of the second pre-charge switch and the second fast-charge switch are the same as those of the first pre-charge switch 1332 and the first fast-charge switch 1331, they are not shown in the drawing as describe above.

Next, in fast-charging the first chargeable power supply 1100 for a fast-charge length of time S33, the controller 1400 allows the first main protection circuit 1120 to turn on the first fast-charge switch 1131 by transmitting the fast-charge start signal to the first main protection circuit 1120 of the first chargeable power supply 1100. That is, the first main protection circuit 1120 is allowed to turn on the first fast-charge switch 1131 coupled between the first battery cell 1110 and the first fuse 1150. At this time, the controller 1400 allows the first pre-charge switch 1132 to be turned off. Moreover, at this time, the controller 1400 allows the second main protection circuit 1220 to turn off the second fast-charge switch by transmitting the fast-charge stop signal to the second main protection circuit 1220. That is, the second main protection circuit 1220 is allowed to turn off the second fast-charge switch coupled between the second battery cell 1210 and the second fuse 1250. At this time, the controller 1400 allows the second pre-charge switch to be turned off. By this operation, the fast-charging current from the charging circuit 1520 is supplied only to the first chargeable power supply 1100. That is, the fast-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus only the first battery cell 1110 is fast-charged.

The controller 1400 operates so that a fast-charging current when fast-charging the first chargeable power supply 1100 is higher than a pre-charging current when pre-charging the first chargeable power supply, and thus allows the first battery cell 1110 to be charged for a short time. When fast-charging the first chargeable power supply 1100, if the voltage of the first battery cell 1110 detected from the first main protection circuit 1120 is, for example, about 4 volts per cell, the controller 1400 performs the pulse charging and allows the charging current to be reduced. This pulse charging can be performed in all regions including a pre-charging region, a fast-charging region and a full-charging region. By fast-charging the first chargeable power supply 1100 as above, the first battery cell 1110 is generally charged up to the charging capacity of about 80%.

Next, in fast-charging the second chargeable power supply 1200 for a fast-charge length of time S34, the controller 1400 allows the second main protection circuit 1220 to turn on the second fast-charge switch by transmitting the fast-charge start signal to the second main protection circuit 1220 of the second chargeable power supply 1200. That is, the second main protection circuit 1220 is allowed to turn on the second fast-charge switch coupled between the second battery cell 1210 and the second fuse 1250. At this time, the controller 1400 allows the second pre-charge switch to be turned off. Moreover, at this time, the controller 1400 allows the first main protection circuit 1120 to turn off the first fast-charge switch 1131 by transmitting the fast-charge stop signal to the first main protection circuit 1120. That is, the first main protection circuit 1120 is allowed to turn off the first fast-charge switch 1131 coupled between the first battery cell 1110 and the first fuse 1150. At this time, the controller 1400 allows the first pre-charge switch 1132 to be turned off. By this operation, the fast-charging current from the charging circuit 1520 is supplied only to the second chargeable power supply 1200. That is, the fast-charging current from the charging circuit 1520 flows through the pack positive electrode terminal P+, the second fuse 1250, the second fast-charge switch, the positive electrode terminal B+ of the second battery cell 1210, the negative electrode terminal B- of the second battery cell 1210 and the sense resistor 1300, and thus only the second battery cell 1210 is fast-charged.

The controller 1400 operates so that a fast-charging current when fast-charging the second chargeable power supply 1200 is higher than a pre-charging current when pre-charging the second chargeable power supply, and thus allows the second battery cell 1210 to be quickly charged. Of course, when fast-charging the second chargeable power supply 1200, if the voltage of the second battery cell 1210 detected from the second main protection circuit 1220 is, for example, about 4 volts per cell, the controller 1400 performs the pulse charging and allows the charging current to be reduced. Of course, as described above, this pulse charging can be performed in all regions including a pre-charging region, a fast-charging region and a full-charging region. By fast-charging the second chargeable power supply 1200 as above, the second battery cell 1210 is generally charged up to the charging capacity of about 80%.

Accordingly, when the fast-charging of the first chargeable power supply 1100 and the second chargeable power supply 1200 is completed, the charging capacity of 80% per pack, i.e., total charging capacity of 160% is obtained. In other words, when charging for the same time, only one battery is charged up to 100% according to a prior art. However, the first and second battery cells are charged up to 160% of one battery according to this embodiment of the present invention.

Next, in full-charging the first chargeable power supply 1100 for a full-charge length of time S35, the controller 1400 allows the first main protection circuit 1120 to turn on the first fast-charge switch 1131 in the form of a pulse by transmitting the full-charge start signal to the first main protection circuit 1120 of the first chargeable power supply 1100. That is, the first main protection circuit 1120 is allowed to turn on not always, but in the form of a pulse, the first fast-charge switch 1131 coupled between the first battery cell 1110 and the first fuse 1150. Moreover, at this time, the controller 1400 allows the second main protection circuit 1220 to turn off the second fast-charge switch by transmitting the fast-charge stop signal to the second main protection circuit 1220. That is, the second main protection circuit 1220 is allowed to turn off the second fast-charge switch coupled between the second battery cell 1210 and the second fuse 1250. By this operation, the full-charging current from the charging circuit 1520 is supplied only to the first chargeable power supply 1100. That is, the full-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus only the first battery cell 1110 is full-charged.

The controller 1400 operates in a pulsed manner so that a full-charging current when full-charging the first chargeable power supply 1100 (that is, as closer to a full-charging voltage) gradually lowers than a fast-charging current when fast-charging the first chargeable power supply. Of course, when the first chargeable power supply 1100 is full-charged, the controller 1400 allows the first main protection circuit 1120 to turn off the first fast-charge switch 1131 by transmitting the full-charge stop signal to the first main protection circuit 1120. By full-charging the first chargeable power supply as above, the first battery cell 1110 generally obtains the remaining charging capacity of 20%, and thus the first battery cell 1110 is charged nearly up to 100%.

Next, in full-charging the second chargeable power supply 1200 for a full-charge length of time S36, the controller 1400 allows the second main protection circuit 1220 to turn on the second fast-charge switch in the form of a pulse by transmitting the full-charge start signal to the second main protection circuit 1220 of the second chargeable power supply 1200. That is, the second main protection circuit 1220 is allowed to turn on not always, but in the form of a pulse, the second fast-charge switch coupled between the second battery cell 1210 and the second fuse 1250. Moreover, at this time, the controller 1400 allows the first main protection circuit 1120 to turn off the first fast-charge switch 1131 by transmitting the fast-charge stop signal to the first main protection circuit 1120. That is, the first main protection circuit 1120 is allowed to turn off the first fast-charge switch 1131 coupled between the first battery cell 1110 and the first fuse 1150. By this operation, the full-charging current from the charging circuit 1520 is supplied only to the second chargeable power supply 1200. That is, the full-charging current from the charging circuit 1520 flows through the pack positive electrode terminal P+, the second fuse 1250, the second fast-charge switch, the positive electrode terminal B+ of the second battery cell 1210, the negative electrode terminal B-of the second battery cell 1210 and the sense resistor 1300, and thus only the second battery cell 1210 is full-charged.

The controller 1400 operates in a pulsed manner so that a full-charging current when full-charging the second chargeable power supply 1200 (that is, as closer to a full-charging voltage) gradually lowers than a fast-charging current when fast-charging the second chargeable power supply. Of course, when the second chargeable power supply 1200 is full-charged, the controller 1400 allows the second main protection circuit 1220 to turn off the second fast-charge switch by transmitting the full-charge stop signal to the second main protection circuit 1220. By full-charging the second chargeable power supply as above, the second battery cell 1210 generally obtains the remaining charging capacity of 20%, and thus the second battery cell 1210 is charged nearly up to 100%.

Fast-charging time of the first chargeable power supply and the second chargeable power supply 1100, 1200 can be nearly the same as full-charging time of the first chargeable power supply and the second chargeable power supply 1100, 1200. For example, if fast-charging time of the first chargeable power supply and the second chargeable power supply 1100, 1200 is approximately an hour respectively, then full-charging time thereof is also approximately an hour respectively. Of course, as described above, battery cells are charged up to 80% by the fast-charging respectively, and the remaining capacity of 20% of the battery cells is charged by the full-charging respectively.

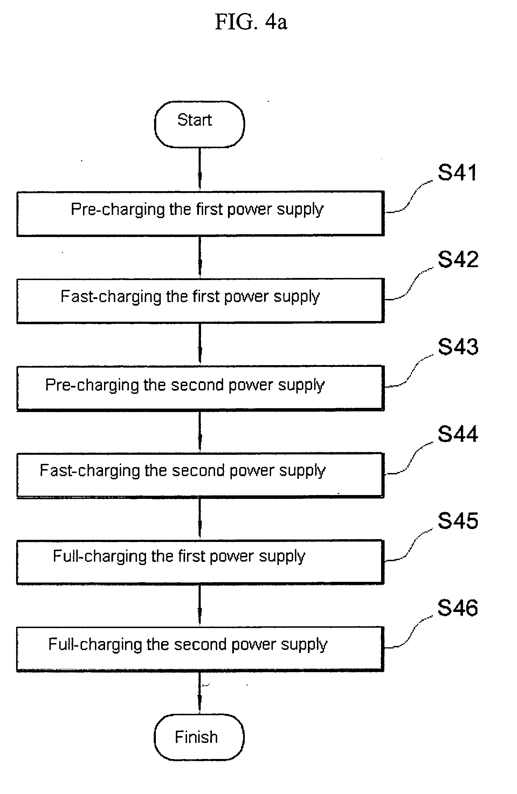

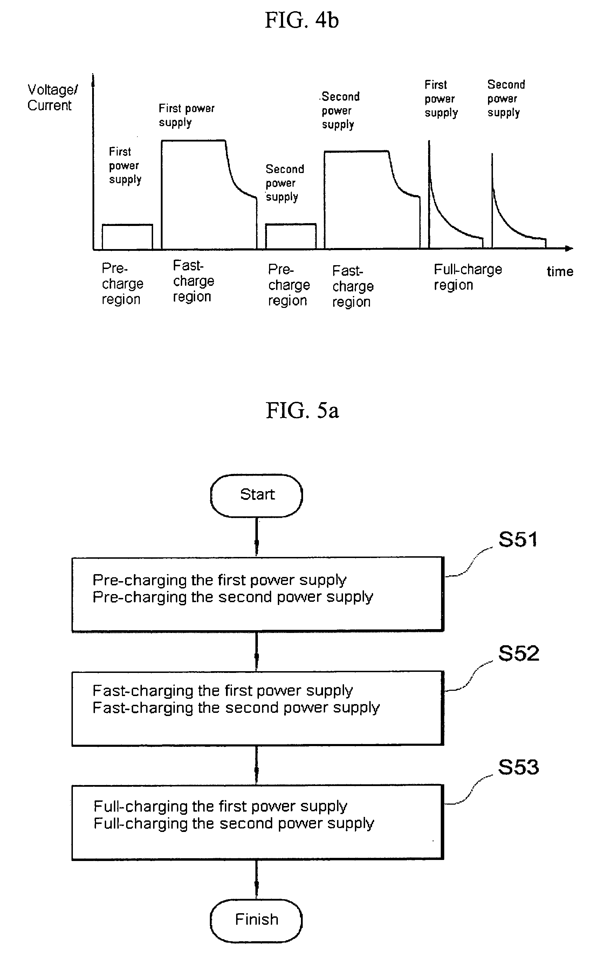

FIGS. 4a and 4b are respectively a flow chart and a timing chart showing a charging method for the hybrid battery 1000 according to another embodiment of the present invention.

As shown in the drawing, a charging method for the hybrid battery 1000 according to an embodiment of the present invention includes: pre-charging the first chargeable power supply 1100 for a pre-charge length of time S41; fast-charging the first chargeable power supply 1100 for a fast-charge length of time S42; pre-charging the second chargeable power supply 1200 for a pre-charge length of time S43; fast-charging the second chargeable power supply 1200 for a fast-charge length of time S44; full-charging the first chargeable power supply 1100 for a full-charge length of time S45; and full-charging the second chargeable power supply 1200 for a full-charge length of time S46.

The charging method for the hybrid battery 1000 according to an embodiment of the present invention will be described more specifically with reference to FIGS. 1, 2a and 2b. It is assumed that the charging circuit 1520 of the external system 1500 is coupled to the pack positive electrode terminal P+ and the pack negative electrode terminal P- and that the first chargeable power supply 1100 and the second chargeable power supply 1200 are all over-discharged.

In pre-charging the first chargeable power supply 1100 for a pre-charge length of time S41, the controller 1400 allows the first main protection circuit 1120 to turn on the first pre-charge switch 1132 by transmitting the pre-charge start signal to the first main protection circuit 1120 of the first chargeable power supply 1100. That is, the first main protection circuit 1120 is allowed to turn on the first pre-charge switch 1132 coupled between the first battery cell 1110 and the first fuse 1150. At this time, the controller 1400 allows the first fast-charge switch to be turned off. Moreover, at this time, the controller 1400 allows the second main protection circuit 1220 to turn off the second pre-charge switch by transmitting the pre-charge stop signal to the second main protection circuit 1220. That is, the second main protection circuit 1220 is allowed to turn off the second pre-charge switch coupled between the second battery cell 1210 and the second fuse 1250. At this time, the controller 1400 allows the second fast-charge switch to be turned off. By this operation, the charging current from the charging circuit 1520 is supplied only to the first chargeable power supply 1100. That is, the charging current from the charging circuit 1520 flows through the pack positive electrode terminal P+, the first fuse 1150, the first pre-charge switch 1132, the positive electrode terminal B+ of the first battery cell 1110, the negative electrode terminal B- of the first battery cell 1110 and the sense resistor 1300, and thus only the first battery cell 1110 is pre-charged.

The controller 1400 operates so that a pre-charging current when pre-charging the first chargeable power supply 1100 is lower than a fast-charging current when fast-charging the first chargeable power supply, and thus prevents the deterioration phenomenon of the first battery cell 1110. Of course, when pre-charging the first chargeable power supply 1100, if the voltage of the first battery cell 1110 detected from the first main protection circuit 1120 is, for example, about 3 volts per cell, the controller 1400 stops the pre-charging for the next fast-charging.

Next, in fast-charging the first chargeable power supply 1100 for a fast-charge length of time S42, the controller 1400 allows the first main protection circuit 1120 to turn on the first fast-charge switch 1131 by transmitting the fast-charge start signal to the first main protection circuit 1120 of the first chargeable power supply 1100. That is, the first main protection circuit 1120 is allowed to turn on the first fast-charge switch 1131 coupled between the first battery cell 1110 and the first fuse 1150. At this time, the controller 1400 allows the first pre-charge switch 1132 to be turned off. Moreover, at this time, the controller 1400 allows the second main protection circuit 1220 to turn off the second fast-charge switch by transmitting the fast-charge stop signal to the second main protection circuit 1220. That is, the second main protection circuit 1220 is allowed to turn off the second fast-charge switch coupled between the second battery cell 1210 and the second fuse 1250. At this time, the controller 1400 allows the second pre-charge switch to be turned off. By this operation, the fast-charging current from the charging circuit 1520 is supplied only to the first chargeable power supply 1100. That is, the fast-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus only the first battery cell 1110 is fast-charged.

The controller 1400 operates so that a fast-charging current when fast-charging the first chargeable power supply 1100 is higher than a pre-charging current when pre-charging the first chargeable power supply, and thus allows the first battery cell 1110 to be quickly charged. Of course, when fast-charging the first chargeable power supply 1100, if the voltage of the first battery cell 1110 detected from the first main protection circuit 1120 is, for example, about 4 volts per cell, the controller 1400 performs the pulse charging and allows the charging current to be reduced. By fast-charging the first chargeable power supply 1100 as above, the first battery cell 1110 is generally charged up to the charging capacity of about 80%.

Next, in pre-charging the second chargeable power supply 1200 for a pre-charge length of time S43, the controller 1400 allows the second main protection circuit 1220 to turn on the second pre-charge switch by transmitting the pre-charge start signal to the second main protection circuit 1220 of the second chargeable power supply 1200. That is, the second main protection circuit 1220 is allowed to turn on the second pre-charge switch coupled between the second battery cell 1210 and the second fuse 1250. At this time, the controller 1400 allows the second fast-charge switch to be turned off. Moreover, at this time, the controller 1400 allows the first main protection circuit 1120 to turn off the first pre-charge switch 1132 by transmitting the pre-charge stop signal to the first main protection circuit 1120. That is, the first main protection circuit 1120 is allowed to turn off the first pre-charge switch 1132 coupled between the first battery cell 1110 and the first fuse 1150. At this time, the controller 1400 allows the first fast-charge switch to be turned off. By this operation, the charging current from the charging circuit 1520 is supplied only to the second chargeable power supply 1200. That is, the charging current from the charging circuit 1520 flows through the pack positive electrode terminal P+, the second fuse 1250, the second pre-charge switch, the positive electrode terminal B+ of the second battery cell 1210, the negative electrode terminal B- of the second battery cell 1210 and the sense resistor 1300, and thus only the second battery cell 1210 is pre-charged.

The controller 1400 operates so that a pre-charging current when pre-charging the second chargeable power supply 1200 is lower than a fast-charging current when fast-charging the second chargeable power supply, and thus prevents the deterioration phenomenon of the second battery cell 1210. Of course, when pre-charging the second chargeable power supply 1200, if the voltage of the second battery cell 1210 detected from the second main protection circuit 1220 is, for example, about 3 volts per cell, the controller 1400 stops the pre-charging for the next fast-charging.

Next, in fast-charging the second chargeable power supply 1200 for a fast-charge length of time S44, the controller 1400 allows the second main protection circuit 1220 to turn on the second fast-charge switch by transmitting the fast-charge start signal to the second main protection circuit 1220 of the second chargeable power supply 1200. That is, the second main protection circuit 1220 is allowed to turn on the second fast-charge switch coupled between the second battery cell 1210 and the second fuse 1250. At this time, the controller 1400 allows the second pre-charge switch to be turned off. Moreover, at this time, the controller 1400 allows the first main protection circuit 1120 to turn off the first fast-charge switch 1131 by transmitting the fast-charge stop signal to the first main protection circuit 1120. That is, the first main protection circuit 1120 is allowed to turn off the first fast-charge switch 1131 coupled between the first battery cell 1110 and the first fuse 1150. At this time, the controller 1400 allows the first pre-charge switch 1132 to be turned off. By this operation, the fast-charging current from the charging circuit 1520 is supplied only to the second chargeable power supply 1200. That is, the fast-charging current from the charging circuit 1520 flows through the pack positive electrode terminal P+, the second fuse 1250, the second fast-charge switch, the positive electrode terminal B+ of the second battery cell 1210, the negative electrode terminal B- of the second battery cell 1210 and the sense resistor 1300, and thus only the second battery cell 1210 is fast-charged.

The controller 1400 operates so that a fast-charging current when fast-charging the second chargeable power supply 1200 is higher than a pre-charging current when pre-charging the second chargeable power supply, and thus allows the second battery cell 1210 to be quickly charged. Of course, when fast-charging the second chargeable power supply 1200, if the voltage of the second battery cell 1210 detected from the second main protection circuit 1220 is, for example, about 4 volts per cell, the controller 1400 performs the pulse charging and allows the charging current to be reduced. By fast-charging the second chargeable power supply 1200 as above, the second battery cell 1210 is generally charged up to the charging capacity of about 80%.

Next, in full-charging the first chargeable power supply 1100 for a full-charge length of time S45, the controller 1400 allows the first main protection circuit 1120 to turn on the first fast-charge switch 1131 in the form of a pulse by transmitting the full-charge start signal to the first main protection circuit 1120 of the first chargeable power supply 1100. That is, the first main protection circuit 1120 is allowed to turn on not always but in the form of a pulse the first fast-charge switch 1131 coupled between the first battery cell 1110 and the first fuse 1150. Moreover, at this time, the controller 1400 allows the second main protection circuit 1220 to turn off the second fast-charge switch by transmitting the fast-charge stop signal to the second main protection circuit 1220. That is, the second main protection circuit 1220 is allowed to turn off the second fast-charge switch coupled between the second battery cell 1210 and the second fuse 1250. By this operation, the full-charging current from the charging circuit 1520 is supplied only to the first chargeable power supply 1100. That is, the full-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus only the first battery cell 1110 is full-charged.

The controller 1400 operates in a pulsed manner so that a full-charging current when full-charging the first chargeable power supply 1100 gradually lowers than a fast-charging current when fast-charging the first chargeable power supply. Of course, when the first chargeable power supply 1100 is full-charged, the controller 1400 allows the first main protection circuit 1120 to turn off the first fast-charge switch 1131 by transmitting the full-charge stop signal to the first main protection circuit 1120. By full-charging the first chargeable power supply as above, the first battery cell 1110 generally obtains the remaining charging capacity of 20%, and thus the first battery cell 1110 is charged nearly up to 100%.

Next, in full-charging the second chargeable power supply 1200 for a full-charge length of time S46, the controller 1400 allows the second main protection circuit 1220 to turn on the second fast-charge switch in the form of a pulse by transmitting the full-charge start signal to the second main protection circuit 1220 of the second chargeable power supply 1200. That is, the second main protection circuit 1220 is allowed to turn on not always, but in the form of a pulse, the second fast-charge switch coupled between the second battery cell 1210 and the second fuse 1250. Moreover, at this time, the controller 1400 allows the first main protection circuit 1120 to turn off the first fast-charge switch 1131 by transmitting the fast-charge stop signal to the first main protection circuit 1120. That is, the first main protection circuit 1120 is allowed to turn off the first fast-charge switch 1131 coupled between the first battery cell 1110 and the first fuse 1150. By this operation, the full-charging current from the charging circuit 1520 is supplied only to the second chargeable power supply 1200. That is, the full-charging current from the charging circuit 1520 flows through the pack positive electrode terminal P+, the second fuse 1250, the second fast-charge switch, the positive electrode terminal B+ of the second battery cell 1210, the negative electrode terminal B-of the second battery cell 1210 and the sense resistor 1300, and thus only the second battery cell 1210 is full-charged.

The controller 1400 operates in a pulsed manner so that a full-charging current when full-charging the second chargeable power supply 1200 gradually lowers than a fast-charging current when fast-charging the second chargeable power supply.
Of course, when the second chargeable power supply 1200 is full-charged, the controller 1400 allows the second main protection circuit 1220 to turn off the second fast-charge switch by transmitting the full-charge stop signal to the second main protection circuit 1220. By full-charging the second chargeable power supply as above, the second battery cell 1210 generally obtains the remaining charging capacity of 20%, and thus the second battery cell 1210 is charged nearly up to 100%.

Fast-charging time of the first chargeable power supply and the second chargeable power supply 1100 and 1200 is nearly the same as full-charging time of the first chargeable power supply and the second chargeable power supply 1100 and 1200. For example, if fast-charging time of the first chargeable power supply and the second chargeable power supply 1100 and 1200 is approximately an hour, then full-charging time thereof is also approximately an hour. Of course, as described above, the battery cells are charged up to 80% by the fast-charging, and the remaining capacity of 20% of the battery cells is charged by the full-charging.

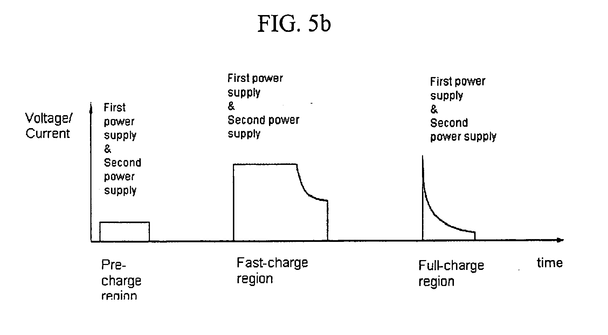

FIGS. 5a and 5b are respectively a flow chart and a timing chart showing a charging method for the hybrid battery 1000 according to another embodiment of the present invention.

As shown in the drawing, a charging method for the hybrid battery 1000 according to an embodiment of the present invention includes: pre-charging simultaneously the first chargeable power supply 1100 and the second chargeable power supply 1200 for a pre-charge length of time S51; fast-charging simultaneously the first chargeable power supply 1100 and the second chargeable power supply 1200 for a fast-charge length of time S52; and full-charging the first chargeable power supply 1100 and the second chargeable power supply 1200 for a full-charge length of time S53.

The charging method for the hybrid battery 1000 according to an embodiment of the present invention will be described more specifically with reference to FIGS. 1, 2a and 2b. It is assumed that the charging circuit 1520 of the external system 1500 is coupled to the pack positive electrode terminal P+ and the pack negative electrode terminal P- and that the first chargeable power supply 1100 and the second chargeable power supply 1200 are all over-discharged.

In pre-charging simultaneously the first chargeable power supply 1100 and the second chargeable power supply 1200 for a pre-charge length of time S51, the controller 1400 allows the first main protection circuit 1120 to turn on the first pre-charge switch 1132 and the second main protection circuit 1220 to turn on the second pre-charge switch by transmitting the pre-charge start signal to the first main protection circuit 1120 of the first chargeable power supply 1100 and the second main protection circuit 1220 of the second chargeable power supply 1200. That is, the first main protection circuit 1120 is allowed to turn on the first pre-charge switch 1132 coupled between the first battery cell 1110 and the first fuse 1150 and the second main protection circuit 1220 is allowed to turn on the second pre-charge switch coupled between the second battery cell 1210 and the second fuse 1250. At this time, the controller 1400 allows the first fast-charge switch and the second fast-charge switch to be turned off. By this operation, the charging current from the charging circuit 1520 is simultaneously supplied to the first chargeable power supply 1100 and the second chargeable power supply 1200. That is, the charging current from the charging circuit 1520 flows through the pack positive electrode terminal P+, the first fuse 1150, the first pre-charge switch 1132, the positive electrode terminal B+ of the first battery cell 1110, the negative electrode terminal B- of the first battery cell 1110 and the sense resistor 1300, and thus the first battery cell 1110 is pre-charged. Moreover, the charging current from the charging circuit 1520 flows through the pack positive electrode terminal P+, the second fuse 1250, the second pre-charge switch, the positive electrode terminal B+ of the second battery cell 1210, the negative electrode terminal B- of the second battery cell 1210 and the sense resistor 1300, and thus the second battery cell 1210 is also pre-charged.

The controller 1400 operates so that a pre-charging current when pre-charging the first chargeable power supply 1100 and the second chargeable power supply 1200 is lower than a fast-charging current when fast-charging the first chargeable power supply and the second chargeable power supply, and thus prevents the deterioration phenomenon of the first battery cell 1110 and the second battery cell 1210. Of course, when pre-charging the first chargeable power supply 1100 and the second chargeable power supply 1200, if the voltage of the first battery cell 1110 detected from the first main protection circuit 1120 and the voltage of the second battery cell 1210 detected from the second main protection circuit 1220 are, for example, about 3 volts per cell respectively, the controller 1400 stops the pre-charging for the next fast-charging.

Next, in fast-charging simultaneously the first chargeable power supply 1100 and the second chargeable power supply 1200 for a fast-charge length of time S52, the controller 1400 allows the first main protection circuit 1120 to turn on the first fast-charge switch 1131 and the second main protection circuit 1220 to turn on the second fast-charge switch by transmitting the fast-charge start signal to the first main protection circuit 1120 of the first chargeable power supply 1100 and the second main protection circuit 1220 of the second chargeable power supply 1200. That is, the first main protection circuit 1120 is allowed to turn on the first fast-charge switch 1131 coupled between the first battery cell 1110 and the first fuse 1150 and the second main protection circuit 1220 is allowed to turn on the second fast-charge switch coupled between the second battery cell 1210 and the second fuse 1250. At this time, the controller 1400 allows the first pre-charge switch 1132 and the second pre-charge switch to be turned off. By this operation, the fast-charging current from the charging circuit 1520 is simultaneously supplied to the first chargeable power supply 1100 and the second chargeable power supply 1200. That is, the fast-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus the first battery cell 1110 is fast-charged. Moreover, the fast-charging current from the charging circuit 1520 flows through the pack positive electrode terminal P+, the second fuse 1250, the second fast-charge switch, the positive electrode terminal B+ of the second battery cell 1210, the negative electrode terminal B- of the second battery cell 1210 and the sense resistor 1300, and thus the second battery cell 1210 is also fast-charged.

The controller 1400 operates so that a fast-charging current when fast-charging the first chargeable power supply 1100 and the second chargeable power supply 1200 is higher than a pre-charging current when pre-charging the first chargeable power supply and the second chargeable power supply, and thus allows the first battery cell 1110 and the second battery cell 1210 to be quickly charged. Of course, when fast-charging the first chargeable power supply 1100 and the second chargeable power supply 1200, if the voltage of the first battery cell 1110 detected from the first main protection circuit 1120 and the voltage of the second battery cell 1210 detected from the second main protection circuit 1220 are, for example, about 4 volts per cell respectively, the controller 1400 performs the pulse charging and allows the charging current to be reduced. By fast-charging the first chargeable power supply 1100 and the second chargeable power supply 1200 as above, the first battery cell 1110 and the second battery cell 1210 are generally charged up to the charging capacity of about 80%.

Next, in full-charging the first chargeable power supply 1100 and the second chargeable power supply 1200 for a full-charge length of time S53, the controller 1400 allows the first main protection circuit 1120 to turn on the first fast-charge switch 1131 in the form of a pulse and the second main protection circuit 1220 to turn on the second fast-charge switch in the form of a pulse by transmitting the full-charge start signal to the first main protection circuit 1120 of the first chargeable power supply 1100 and the second main protection circuit 1220 of the second chargeable power supply 1200. That is, the first main protection circuit 1120 is allowed to turn on not always, but in the form of a pulse, the first fast-charge switch 1131 coupled between the first battery cell 1110 and the first fuse 1150. Moreover, the second main protection circuit 1220 is allowed to turn on not always but in the form of a pulse the second fast-charge switch coupled between the second battery cell 1210 and the second fuse 1250. By this operation, the full-charging current from the charging circuit 1520 is supplied to the first chargeable power supply 1100 and the second chargeable power supply 1200 respectively. That is, the full-charging current from the charging circuit 1520 flows through the pack positive electrode terminal P+, the first fuse 1150, the first fast-charge switch 1131, the positive electrode terminal B+ of the first battery cell 1110, the negative electrode terminal B- of the first battery cell 1110 and the sense resistor 1300, and thus the first battery cell 1110 is full-charged. Moreover, the full-charging current from the charging circuit 1520 flows through the pack positive electrode terminal P+, the second fuse 1250, the second fast-charge switch, the positive electrode terminal B+ of the second battery cell 1210, the negative electrode terminal B- of the second battery cell 1210 and the sense resistor 1300, and thus the second battery cell 1210 is also full-charged.

The controller 1400 operates in a pulsed manner so that a full-charging current when full-charging the first chargeable power supply 1100 and the second chargeable power supply 1200 gradually lowers than a fast-charging current when fast-charging the first chargeable power supply and the second chargeable power supply. Of course, when the first chargeable power supply 1100 and the second chargeable power supply 1200 are full-charged respectively, the controller 1400 allows the first main protection circuit 1120 to turn off the first fast-charge switch 1131 and the second main protection circuit 1220 to turn off the second fast-charge switch by transmitting the full-charge stop signal to the first main protection circuit 1120 and the second main protection circuit 1220. By full-charging the first chargeable power supply and the second chargeable power supply as above, the first battery cell 1110 and the second battery cell 1210 generally obtain the remaining charging capacity of 20%, and thus the first battery cell 1110 and the second battery cell 1210 are charged nearly up to 100% respectively.

Fast-charging time of the first chargeable power supply and the second chargeable power supply 1100, 1200 is nearly the same as full-charging time of the first chargeable power supply and the second chargeable power supply. For example, if fast-charging time of the first chargeable power supply and the second chargeable power supply 1100, 1200 is approximately an hour, then full-charging time thereof is also approximately an hour. Of course, as described above, the battery cells are charged up to 80% by the fast-charging, and the remaining capacity of 20% of the battery cells is charged by the full-charging.

According to the hybrid battery and its charging method for an embodiment of the present invention, it is possible to maximize the charging capacity per charging time by pre-charging, fast-charging and full-charging the first chargeable power supply and the second chargeable power supply sequentially or in parallel. For example, if the charging capacity of about 80% is obtained by fast-charging for about an hour, then the remaining charging capacity of 20% is obtained by full-charging for about an hour. That is, the charging capacity of about 100% is obtained by full-charging for about an hour. Hence, when the first chargeable power supply is fast-charged for an hour and then the second chargeable power supply is subsequently fast-charged for an hour, the charging capacity of 80% per each battery is obtained. In other words, the total charging capacity of the first chargeable power supply and the second chargeable power supply becomes 160%. On the contrary, if the first chargeable power supply is fast-charged (for an hour) and full-charged (for an hour) for two hours and then the charging is stopped as in a prior art, then only the first chargeable power supply obtains the charging capacity of 100% and the second chargeable power supply obtains the charging capacity of 0%. However, if the charging is carried out in accordance with the charging method of embodiments of the present invention, then the first chargeable power supply and the second chargeable power supply obtain the charging capacity of 80% respectively (the total charging capacity is 160%) and obtain 80% higher charging capacity than a prior art. The pre-charging is not considered.

Moreover, according to embodiments of the present invention, a single controller operates the charging of the first chargeable power supply and the second chargeable power supply in a combined manner, and thus the circuit is simplified and the manufacturing cost is lowered. In some embodiments of the invention, the controller is arranged such that the pre-charging and the fast-charging of the first chargeable power supply and the second chargeable power supply is carried out before the full-charging of the first chargeable power supply and the second chargeable power supply. Therefore, both the first chargeable power supply and the second chargeable power supply are charged to a charging capacity of about 80% after fast-charging before the full-charging is carried out to provide the remaining charging capacity of about 20% of each chargeable power supply.

Furthermore, according to embodiments of the present invention, the first chargeable power supply and the second chargeable power supply having different shapes, chemical properties, capacities, charging voltages or charging currents from each other are employed, and thus the space can be much saved and the energy efficiency per volume can be raised.

Although exemplary embodiments of the hybrid battery and its charging method and discharging method according to embodiments of the present invention have been described for illustrative purposes, those skilled in the art will appreciate that various modifications and changes thereof are possible without departing from the scope and the present invention, and all modifications and changes are intended to be included within the description of the claims.

## Claims

1. A hybrid battery comprising:
a first chargeable power supply;
a second chargeable power supply coupled in parallel with the first chargeable power supply; and
a controller for sequentially controlling pre-charging, fast-charging and full-charging of the first chargeable power supply and the second chargeable power supply while sensing a charging voltage of the first chargeable power supply and a charging voltage of the second chargeable power supply.

2. A hybrid battery according to claim 1, wherein the controller is arranged such that the pre-charging and the fast-charging of the first chargeable power supply and the second chargeable power supply is carried out before the full-charging of the first chargeable power supply and the second chargeable power supply.

3. A hybrid battery according to claim 1 or 2, wherein the controller is arranged such that the pre-charging of the first chargeable power supply and the second chargeable power supply is carried out sequentially for a pre-charge length of time, then the fast-charging of the first chargeable power supply and the second chargeable power supply is carried out sequentially for a fast-charge length of time, and then the full-charging of the first chargeable power supply and the second chargeable power supply is carried out sequentially for a full-charge length of time.

4. A hybrid battery according to claim 1 or 2, wherein the controller is arranged such that the pre-charging and the fast-charging of the first chargeable power supply is carried out sequentially for a respective pre-charge length of time and a fast-charge length of time, then the pre-charging and the fast-charging of the second chargeable power supply is carried out sequentially for the respective pre-charge length of time and the fast-charge length of time, and then the full-charging of the first chargeable power supply and the second chargeable power supply is carried out sequentially for a full-charge length of time.

5. A hybrid battery according to any one of claims 1 to 4, wherein the first chargeable power supply and the second chargeable power supply include a first pre-charge switch and a second pre-charge switch respectively, and when controlling the pre-charging of the first chargeable power supply, the controller is arranged to turn on the first pre-charge switch and turn off the second pre-charge switch of the second chargeable power supply, and when controlling the pre-charging of the second chargeable power supply, the controller is arranged to turn on the second pre-charge switch and turn off the first pre-charge switch of the first chargeable power supply.

6. A hybrid battery according to any one of claims 1 to 5, wherein the first chargeable power supply and the second chargeable power supply include a first fast-charge switch and a second fast-charge switch respectively, and when controlling the fast-charging or full-charging of the first chargeable power supply, the controller is arranged to turn on the first fast-charge switch and turn off the second fast-charge switch of the second chargeable power supply, and when controlling the fast-charging or full-charging of the second chargeable power supply, the controller is arranged to turn on the second fast-charge switch and turn off the first fast-charge switch of the first chargeable power supply.

7. A hybrid battery according to any one of claims 1 to 6, wherein the controller is arranged to operate so that a pre-charging current applied when pre-charging the first chargeable power supply and the second chargeable power supply is lower than a fast-charging current applied when fast-charging the first chargeable power supply and the second chargeable power supply, and the controller is arranged to operate so that a full-charging current applied when full-charging the first chargeable power supply and the second chargeable power supply gradually lowers as time elapses.

8. A hybrid battery according to claim 1 or 2, wherein:
the controller is arranged such that the pre-charging of the first chargeable power supply and the second chargeable power supply is carried out simultaneously for a pre-charge length of time, then the fast-charging of the first chargeable power supply and the second chargeable power supply is carried out simultaneously for a fast-charge length of time, and then the full-charging of the first chargeable power supply and the second chargeable power supply is carried out simultaneously for a full-charge length of time.

9. A hybrid battery according to claim 8, wherein the first chargeable power supply and the second chargeable power supply include a first pre-charge switch and a second pre-charge switch respectively, and the controller is arranged to turn on simultaneously the first pre-charge switch and the second pre-charge switch when controlling the simultaneous pre-charging of the first chargeable power supply and the second chargeable power supply.

10. The hybrid battery as claimed in claim 8 or 9, wherein the first chargeable power supply and the second chargeable power supply include a first fast-charge switch and a second fast-charge switch respectively, and the controller is arranged to turn on simultaneously the first fast-charge switch and the second fast-charge switch when controlling the simultaneous fast-charging or full-charging of the first chargeable power supply and the second chargeable power supply.

11. A hybrid battery according to any one of claims 8 to10, wherein the controller is arranged to operate so that a pre-charging current applied when pre-charging the first chargeable power supply and the second chargeable power supply is lower than a fast-charging current applied when fast-charging the first chargeable power supply and the second chargeable power supply, and the controller is arranged to operate so that a full-charging current applied when full-charging the first chargeable power supply and the second chargeable power supply gradually lowers as time elapses.

12. The hybrid battery according to any preceding claim, wherein the first chargeable power supply and the second chargeable power supply each comprise a battery selected from a cylindrical lithium ion battery, a polygonal lithium ion battery, a pouch-shaped lithium polymer battery and a pouch-shaped lithium ion battery.

13. A hybrid battery according to any preceding claim, wherein the first chargeable power supply and the second chargeable power supply comprise battery cells that differ from each other in at least one of shape, chemical property, capacity, charging voltage and charging current.

14. A charging method for a hybrid battery having a first chargeable power supply and a second chargeable power supply coupled in parallel, comprising:
using a controller to control the pre-charging, fast-charging and full-charging of the first chargeable power supply and the second chargeable power supply while sensing a charging voltage at the first chargeable power supply and a charging voltage of the second chargeable power supply.

15. A charging method according to claim 14, wherein the method comprises pre-charging and fast-charging the first chargeable power supply and the second chargeable power supply before full-charging the first chargeable power supply and the second chargeable power supply.

16. A charging method for a hybrid battery according to claim 14 or 15, wherein the pre-charging, fast-changing and full-changing of the first and second changeable power supplied is carried out in the following order:
pre-charging the first chargeable power supply for a pre-charge length of time;
pre-charging the second chargeable power supply for the pre-charge length of time;
fast-charging the first chargeable power supply for a fast-charge length of time;
fast-charging the second chargeable power supply for the fast-charge length of time;
full-charging the first chargeable power supply for a full-charge length of time; and
full-charging the second chargeable power supply for the full-charge length of time.

17. A charging method according to claim 16, wherein a pre-charging current applied when pre-charging the first chargeable power supply and the second chargeable power supply is lower than a fast-charging current applied when fast-charging the first chargeable power supply and the second chargeable power supply, and a full-charging current applied when full-charging the first chargeable power supply and the second chargeable power supply gradually lowers as time elapses.

18. A charging method for a hybrid battery according to claim 14 or 15, wherein the pre-charging, fast-changing and full-changing of the first and second changeable power supplied is carried out in the following order:
pre-charging the first chargeable power supply for a pre-charge length of time;
fast-charging the first chargeable power supply for a fast-charge length of time;
pre-charging the second chargeable power supply for the pre-charge length of time;
fast-charging the second chargeable power supply for the fast-charge length of time;
full-charging the first chargeable power supply for a full-charge length of time; and
full-charging the second chargeable power supply for the full-charge length of time.

19. A charging method according to claim 18, wherein a pre-charging current applied when pre-charging the first chargeable power supply and the second chargeable power supply is lower than a fast-charging current applied when fast-charging the first chargeable power supply and the second chargeable power supply, and a full-charging current applied when full-charging the first chargeable power supply and the second chargeable power supply gradually lowers as time elapses.

20. A charging method for a hybrid battery according to claim 14 or 15, wherein the pre-charging, fast-changing and full-changing of the first and second changeable power supplied is carried out in the following order:
pre-charging simultaneously the first chargeable power supply and the second chargeable power supply for a pre-charge length of time;
fast-charging simultaneously the first chargeable power supply and the second chargeable power supply for a fast-charge length of time; and
full-charging the first chargeable power supply and the second chargeable power supply for a full-charge length of time.

21. A charging method according to claim 20, wherein a pre-charging current applied when pre-charging the first chargeable power supply and the second chargeable power supply is lower than a fast-charging current applied when fast-charging the first chargeable power supply and the second chargeable power supply, and a full-charging current applied when full-charging the first chargeable power supply and the second chargeable power supply gradually lowers as time elapses.
